(19) Europäisches Patentamt
European Patent Office
Office européen des brevets

(11) **EP 3 346 389 B1**

(12) **FASCICULE DE BREVET EUROPEEN**

(45) Date de publication et mention de la délivrance du brevet:
**31.12.2025 Bulletin 2026/01**

(51) Classification Internationale des Brevets (IPC):
**G06F 17/10** (2006.01)  **H03M 1/00** (2006.01)
**H03M 7/00** (2006.01)

(21) Numéro de dépôt: **18150450.7**

(22) Date de dépôt: **05.01.2018**

(52) Classification Coopérative des Brevets (CPC):
**G06F 17/10; H03M 7/00; H03M 7/3062;
H03M 7/3082**

(54) **TRAITEMENT À LA VOLÉE DE DONNÉES DANS UN SYSTÈME D'ACQUISITION**

SOFORT-DATENVERARBEITUNG IN EINEM ERFASSUNGSSYSTEM

ON-THE-FLY PROCESSING OF DATA IN AN ACQUISITION SYSTEM

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **09.01.2017 FR 1750160**

(43) Date de publication de la demande:
**11.07.2018 Bulletin 2018/28**

(73) Titulaire: **Commissariat à l'Energie Atomique et
aux Energies
Alternatives
75015 Paris (FR)**

(72) Inventeurs:
• **GUICQUERO, William
91440 BURES-SUR-YVETTE (FR)**
• **VERDANT, Arnaud
38330 SAINT-NAZAIRE-LES-EYMES (FR)**

(74) Mandataire: **Cabinet Beaumont
4, Place Robert Schuman
B.P. 1529
38025 Grenoble Cedex 1 (FR)**

(56) Documents cités:
• **MARCO F DUARTE ET AL: "Structured Compressed Sensing: From Theory to Applications", ARXIV.ORG, CORNELL UNIVERSITY LIBRARY, 201 OLIN LIBRARY CORNELL UNIVERSITY ITHACA, NY 14853, 30 June 2011 (2011-06-30), XP080512894, DOI: 10.1109/TSP.2011.2161982**

• **LI KEZHI ET AL: "State of the art and prospects of structured sensing matrices in compressed sensing", FRONTIERS OF COMPUTER SCIENCE, SPRINGER BERLIN HEIDELBERG, BERLIN/ HEIDELBERG, vol. 9, no. 5, 13 May 2015 (2015-05-13), pages 665 - 677, XP035537032, ISSN: 2095-2228, [retrieved on 20150513], DOI: 10.1007/S11704-015-3326-8**

• **HEMANT KUMAR AGGARWAL ET AL: "Compressive sensing multi-spectral demosaicing from single sensor architecture", 2014 IEEE CHINA SUMMIT & INTERNATIONAL CONFERENCE ON SIGNAL AND INFORMATION PROCESSING (CHINASIP), 9 July 2014 (2014-07-09), pages 334 - 338, XP055420664, ISBN: 978-1-4799-5401-8, DOI: 10.1109/ ChinaSIP.2014.6889259**

• **HOOVER RUEDA ET AL: "Multi-spectral compressive snapshot imaging using RGB image sensors", OPTICS EXPRESS, vol. 23, no. 9, 4 May 2015 (2015-05-04), pages 12207, XP055420666, ISSN: 2161-2072, DOI: 10.1364/ OE.23.012207**

• **LORENZI LUCA ET AL: "Adaptive basis pursuit compressive sensing reconstruction with histogram matching", 2013 IEEE INTERNATIONAL GEOSCIENCE AND REMOTE SENSING SYMPOSIUM - IGARSS, IEEE, 21 July 2013 (2013-07-21), pages 872 - 875, XP032558648, ISSN: 2153-6996, [retrieved on 20140123], DOI: 10.1109/IGARSS.2013.6721298**

- NIKOLA KATIC ET AL: "Column-separated compressive sampling scheme for low power CMOS image sensors", NEW CIRCUITS AND SYSTEMS CONFERENCE (NEWCAS), 2013 IEEE 11TH INTERNATIONAL, IEEE, 16 June 2013 (2013-06-16), pages 1 - 4, XP032447571, ISBN: 978-1-4799-0618-5, DOI: 10.1109/ NEWCAS.2013.6573620

- RIT SCHOLAR WORKS ET AL: "Rochester Institute of Technology Schroedinger Eigenmaps for Manifold Alignment of Multimodal Hyperspectral Images", 10 April 2016 (2016-04-10), XP055693527, Retrieved from the Internet <URL:https://scholarworks.rit.edu/cgi/ viewcontent.cgi?article=10446&context=theses> [retrieved on 20200511]

# EP 3 346 389 B1

## Description

<u>Domaine</u>

La présente demande concerne le domaine du traitement à la volée de données dans un système d'acquisition de données. Elle vise plus particulièrement un système d'acquisition de données comportant un capteur adapté à fournir de façon séquentielle une pluralité de valeurs mesurées, et un dispositif de traitement à la volée des valeurs fournies par le capteur, le dispositif de traitement permettant de réaliser une projection ou transposition d'un ensemble de valeurs fournies par le capteur pendant un intervalle de temps, dans un domaine de représentation spécifique distinct du domaine d'acquisition. La solution proposée sera décrite plus particulièrement en relation avec des exemples d'application à des systèmes d'imagerie. D'autres applications sont toutefois possibles.

<u>Exposé de l'art antérieur</u>

Dans de nombreuses applications, un capteur d'images est couplé à un dispositif de traitement permettant d'extraire, à partir des images acquises par le capteur, des informations utiles pour l'application.

De façon classique, le dispositif de traitement est adapté à transposer ou projeter une image acquise par le capteur dans un domaine de représentation spécifique distinct du domaine d'acquisition, de façon à exacerber certaines caractéristiques de l'image choisies en fonction de l'application considérée.

Par exemple, dans une application de détection de visages, l'image fournie par le capteur peut être projetée dans un domaine de représentation choisi pour faire ressortir un motif particulier, aisément détectable, lorsqu'un visage est présent dans l'image.

L'opération de projection de l'image s'accompagne généralement d'une réduction de dimensions, c'est-à-dire que la dimension (nombre de valeurs) de la projection de l'image est généralement inférieure à la dimension de l'image d'origine. Ceci permet de réduire la complexité et les besoins en mémoire et en ressources énergétiques d'éventuels traitements ultérieurs.

La projection d'une image fournie par le capteur dans un domaine de représentation distinct du domaine d'acquisition est classiquement réalisée en multipliant l'image d'origine par une matrice de passage. Cette opération nécessite toutefois des ressources mémoires et calculatoires relativement importantes. Ceci peut poser problème dans certaines applications, par exemple des applications dites temps réel, dans lesquelles on souhaite pouvoir traiter les images à la volée, au fur et à mesure de leur acquisition par le capteur.

Il serait souhaitable de pouvoir disposer d'un système d'acquisition comportant un capteur adapté à fournir successivement une pluralité de valeurs mesurées, et un dispositif de traitement à la volée des valeurs fournies par le capteur, le dispositif de traitement permettant de réaliser une projection d'un ensemble de valeurs fournies par le capteur dans un domaine de représentation distinct du domaine d'acquisition, ce système palliant tout ou partie des inconvénients des systèmes connus.

Les documents :

M. F. Duarte and Y. C. Eldar, "Structured Compressed Sensing: From Theory to Applications," dans IEEE Transactions on Signal Processing, vol. 59, no. 9, pp. 4053-4085, Sept. 2011; et
Johnson, Juan Emmanuel, "Schroedinger Eigenmaps for Manifold Alignment of Multimodal Hyperspectral Images" (2016). Thesis. Rochester Institute of Technology. Accessed from https://repository.rit.edu/theses/9324, décrivent des exemples de systèmes de traitement de données.

<u>Résumé</u>

Ainsi, un mode de réalisation prévoit un système électronique comportant :

un capteur adapté à fournir successivement n vecteurs $L_i$ comportant chacun k valeurs mesurées $L_i(j)$, où n et k sont des entiers avec $n \geq 2$ et $k \geq 1$, i est un entier allant de 1 à n, et j est un entier allant de 1 à k ; et
un dispositif électronique de traitement à la volée des valeurs mesurées par le capteur adapté à fournir une projection $\check{G}(A,B)*I$, dans un domaine de représentation de dimension p, de l'ensemble des n*k valeurs $L_i(j)$ mesurées par le capteur, p étant un entier avec $p \geq 1$, I étant un vecteur colonne de n*k valeurs, constitué par l'ensemble des n*k valeurs $L_i(j)$ mesurées par le capteur, et $\check{G}(A,B)$ étant une matrice de projection de p lignes et n*k colonnes telle que $G(A,B) = S*A*B$, où B est une matrice carrée diagonale de n*k lignes par n*k colonnes, et A est une matrice de n*k colonnes par p*n lignes constituée de p*k sous-matrices carrées de dimensions n*n disposées selon p lignes et k colonnes, chaque sous-matrice carrée étant une matrice diagonale dont les n valeurs de la diagonale sont identiques, et où S est une matrice de p lignes par p*n colonnes dont chaque ligne de rang l, avec l entier allant de 1 à p, est constituée par un

3

vecteur comprenant $(l-1)*n$ coefficients nuls suivis de n coefficients unitaires suivis de $(p-l)*n$ nuls, le dispositif électronique de traitement comportant :

- un premier étage adapté, à chaque fourniture d'un vecteur $L_i$ par le capteur et avant la fourniture du vecteur $L_i$ suivant, à multiplier les k valeurs $L_i(j)$ du vecteur $L_i$ par respectivement k coefficients $b_i(j)$, et à fournir un vecteur $T1_i$ de k valeurs $T1_i(j)$ résultant de cette multiplication ;
- un deuxième étage adapté, à chaque fourniture d'un vecteur $T1_i$ par le premier étage et avant la fourniture du vecteur $T1_i$ suivant, à multiplier le vecteur $T1_i$ par une matrice $\tilde{A}$ de $k*p$ coefficients, et à fournir un vecteur $T2_i$ de p valeurs $T2_i(l)$ résultant de cette multiplication, où 1 est un entier allant de 1 à p ; et
- un troisième étage adapté à intégrer numériquement les n vecteurs $T2_i$ successivement fournis par le deuxième étage, et à fournir un vecteur de sortie IT de p valeurs IT(l), correspondant à la projection $G(A,B)*I$.

Un autre mode de réalisation prévoit un système électronique comportant :

un capteur adapté à fournir successivement n vecteurs $L_i$ comportant chacun k valeurs mesurées $L_i(j)$, où n et k sont des entiers avec $n \geq 2$ et $k \geq 1$, i est un entier allant de 1 à n, et j est un entier allant de 1 à k ; et un dispositif électronique de traitement à la volée des valeurs mesurées par le capteur adapté à fournir une projection $\check{G}(A,B)*I$, dans un domaine de représentation de dimension p, de l'ensemble des $n*k$ valeurs $L_i(j)$ mesurées par le capteur, p étant un entier avec $p \geq 1$, I étant un vecteur colonne de $n*k$ valeurs, constitué par l'ensemble des $n*k$ valeurs $L_i(j)$ mesurées par le capteur, et $\check{G}(A,B)$ étant une matrice de projection de p lignes et $n*k$ colonnes telle que $\check{G}(A,B) = S*B*A$, où B est une matrice carrée diagonale de $p*n$ colonnes par $p*n$ lignes, où A est une matrice de $n*k$ colonnes par $p*n$ lignes constituée de $p*k$ sous-matrices carrées de dimensions $n*n$ disposées selon p lignes et k colonnes, chaque sous matrice carrée étant une matrice diagonale dont les n valeurs de la diagonale sont identiques, et où S est une matrice de p lignes par $p*n$ colonnes dont chaque ligne de rang l, avec l entier allant de 1 à p, est constituée par un vecteur comprenant $(l-1)*n$ coefficients nuls suivis de n coefficients unitaires suivis de $(p-l)*n$ nuls, le dispositif électronique de traitement comportant :

- un premier étage adapté, à chaque fourniture d'un vecteur $L_i$ par le capteur et avant la fourniture du vecteur $L_i$ suivant, à multiplier le vecteur $L_i$ par une matrice $\tilde{A}$ de $k*p$ coefficients, et à fournir un vecteur $T1_i$ de p valeurs $T1_i(l)$ résultant de cette multiplication, où 1 est un entier allant de 1 à p ;
- un deuxième étage adapté, à chaque fourniture d'un vecteur $T1_i$ par le premier étage et avant la fourniture du vecteur $T1_i$ suivant, à multiplier les p valeurs $T1_i(l)$ du vecteur $T1_i$ par respectivement p coefficients $b_i(l)$, et à fournir un vecteur $T2_i$ de p valeurs $T2_i(l)$ résultant de cette multiplication ; et
- un troisième étage adapté à intégrer numériquement les n vecteurs $T2_i$ successivement fournis par le deuxième étage, et à fournir un vecteur de sortie IT de p valeurs IT(l), correspondant à la projection $\check{G}(A,B)*I$.

Selon un mode de réalisation, les premier, deuxième et troisième étages sont cascadés et sont cadencés par un même signal d'horloge, de façon que chaque étage réalise l'opération de calcul qui lui est attribuée entre deux fronts montants ou descendants consécutifs du signal d'horloge.

Selon un mode de réalisation, k est un entier supérieur ou égal à 2.

Selon un mode de réalisation, le dispositif de traitement comporte en outre un quatrième étage adapté à recevoir le vecteur IT de dimension p fourni par le troisième étage, et à prendre une ou plusieurs décisions en fonction de la valeur du vecteur IT.

Selon un mode de réalisation, le quatrième étage est adapté à classer l'ensemble des $n*k$ valeurs mesurées par le capteur dans une catégorie choisie parmi une pluralité de catégories prédéfinies, en fonction de la valeur du vecteur IT.

Selon un mode de réalisation, le quatrième étage est adapté à commander un dispositif électronique utilisateur en fonction de la valeur du vecteur IT.

Selon un mode de réalisation, le capteur est un capteur d'images comportant une pluralité de pixels disposés selon n lignes et k colonnes, adapté à fournir successivement n vecteurs $L_i$, chaque vecteur $L_i$ correspondant à l'ensemble des valeurs de sortie des pixels d'une même ligne du capteur.

Selon un mode de réalisation, les valeurs de sortie des pixels du capteur sont des valeurs numériques quantifiées sur plusieurs bits.

Selon un mode de réalisation, les valeurs de sortie des pixels du capteur sont des valeurs binaires, et le capteur est lu une pluralité de fois, le dispositif de traitement fournissant, à chaque lecture, une projection de l'image binaire fournie par le capteur, le système étant adapté à additionner les projections des images binaires successivement fournies par le dispositif de traitement pour fournir une image projetée finale.

Selon un mode de réalisation, le capteur est un capteur d'histogrammes comportant un capteur photosensible multi-spectral asynchrone et un circuit de construction d'histogrammes dont une entrée est reliée à une sortie du capteur photosensible.

Selon un mode de réalisation, le circuit de construction d'histogrammes est adapté à fournir k histogrammes d'une scène vue par le capteur photosensible, correspondant respectivement à k bandes spectrales différentes de la scène.

Selon un mode de réalisation, le circuit de construction d'histogrammes est adapté à fournir, pour chaque bande spectrale, m histogrammes de la scène présentant des échelles différentes.

Selon un mode de réalisation, le système comporte une pluralité de capteurs identiques juxtaposés, et, pour chaque capteur, un dispositif électronique de traitement à la volée des valeurs mesurées par le capteur, le système étant adapté à, pour chaque capteur, classer un ensemble de valeurs mesurées par le capteur dans une catégorie choisie parmi une pluralité de catégories prédéfinies, en fonction de la valeur du vecteur IT calculé par le dispositif de traitement associé au capteur.

Selon un mode de réalisation, le système comprend en outre un dispositif électronique d'apprentissage comprenant :

- une mémoire de référence stockant au moins une valeur de référence correspondant par exemple à des coefficients d'une projection de référence G ou à au moins un couple de valeurs d'entrée/sortie de référence, chaque couple incluant un vecteur de référence I et un vecteur de référence IT associé attendu ;
- un dispositif de calcul d'optimum apte à rechercher des coefficients des matrices A et B permettant de s'approcher au mieux de ladite au moins une valeur de référence ; et
- un dispositif d'écriture des coefficients des matrices A et B dans une mémoire de stockage du dispositif électronique de traitement, les valeurs mémorisées pouvant être modifiées pendant un processus d'apprentissage sur requête du dispositif de calcul d'optimum.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 illustre schématiquement un exemple d'une opération de projection, dans un domaine de représentation spécifique, d'une image fournie par un capteur d'images ;

la figure 2 est un schéma bloc d'un exemple de système d'acquisition comportant un capteur d'images et un dispositif de traitement adapté à mettre en oeuvre une opération de projection, dans un domaine de représentation spécifique, d'une image fournie par le capteur ;

la figure 3 illustre schématiquement un exemple d'un mode de réalisation d'une opération de projection, dans un domaine de représentation spécifique, d'une image fournie par un capteur d'images ;

la figure 4 est un schéma bloc d'un exemple d'un mode de réalisation d'un système d'acquisition comportant un capteur d'images et un dispositif de traitement adapté à mettre en oeuvre une opération de projection, dans un domaine de représentation spécifique, d'une image fournie par le capteur ;

la figure 5 illustre schématiquement un autre exemple d'un autre mode de réalisation d'une opération de projection, dans un domaine de représentation spécifique, d'une image fournie par un capteur d'images ;

la figure 6 est un schéma bloc d'un autre exemple d'un mode de réalisation d'un système d'acquisition comportant un capteur d'images et un dispositif de traitement adapté à mettre en oeuvre une opération de projection, dans un domaine de représentation spécifique, d'une image fournie par le capteur ;

la figure 7 représente de façon schématique un exemple d'un capteur de données d'un système d'acquisition de données selon un mode de réalisation ;

la figure 8 est un chronogramme représentant de façon schématique des données mesurées par le capteur de la figure 7 ;

la figure 9 représente de façon schématique un autre exemple d'un capteur de données d'un système d'acquisition de données selon un mode de réalisation ; et

la figure 10 est un chronogramme représentant de façon schématique des données mesurées par le capteur de la figure 9.

Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, les capteurs des systèmes d'acquisition décrits ci-après n'ont pas été détaillés, les modes de réalisation décrits étant compatibles avec tout capteur adapté à fournir, de façon séquentielle, des signaux électriques représentatifs de valeurs mesurées par le capteur. De plus, les circuits électroniques adaptés à mettre en oeuvre les opérations décrites par la suite de traitement des signaux fournis par les capteurs, n'ont pas été détaillés, l'implémentation de tels circuits étant à la portée de l'homme du métier à partir des indications fonctionnelles de la présente description. On notera en particulier que les opérations de traitement décrites ci-après peuvent être implémentées en totalité ou en partie par un circuit de calcul générique, comportant par exemple un microprocesseur, programmé pour mettre en oeuvre les opérations de traitement décrites. Alternativement, les opérations de traitement décrites ci-après peuvent être implémentées en totalité ou en partie par des circuits électroniques spécifiques. Par ailleurs, l'ensemble des applications dans lesquelles des systèmes d'acquisition du type décrit ci-après peuvent être utilisés n'ont pas été détaillées, les modes de réalisation décrits pouvant être adaptés à toute application dans laquelle on souhaite projeter, dans un domaine de représentation spécifique, un ensemble de données fournies de façon séquentielle par un capteur. Sauf précision contraire, les expressions "approximativement", "sensiblement", et "de l'ordre de" signifient à 10 % près, de préférence à 5 % près.

Comme indiqué ci-dessus, on s'intéresse ici de façon générale à des systèmes électroniques dans lesquels un capteur fournit de façon séquentielle des données ou signaux représentatifs de valeurs mesurées par le capteur.

A titre d'exemple illustratif, on considère un système comportant un capteur d'images comportant $n*k$ pixels agencés en matrice selon n lignes et k colonnes, où n et k sont des entiers. Dans cet exemple, lors d'une phase de lecture d'une image acquise par le capteur, les valeurs de sortie des pixels sont lues ligne par ligne, c'est-à-dire que tous les pixels d'une même ligne sont lus simultanément, et que les pixels de lignes distinctes sont lus séquentiellement. Autrement dit, lors d'une phase de lecture d'une image acquise par le capteur, le capteur fournit successivement n vecteurs $L_1$, ..., $L_n$, chaque vecteur $L_i$ (avec i entier allant de 1 à n) comportant k valeurs $L_i(1)$, ... $L_i(k)$, chaque valeur $L_i(j)$ (avec j entier allant de 1 à k) correspondant à la valeur de sortie du pixel de la ligne de rang i et de la colonne de rang j. L'image I fournie par le capteur est constituée par l'ensemble des $n*k$ valeurs $L_i(j)$ lues pendant la phase de lecture.

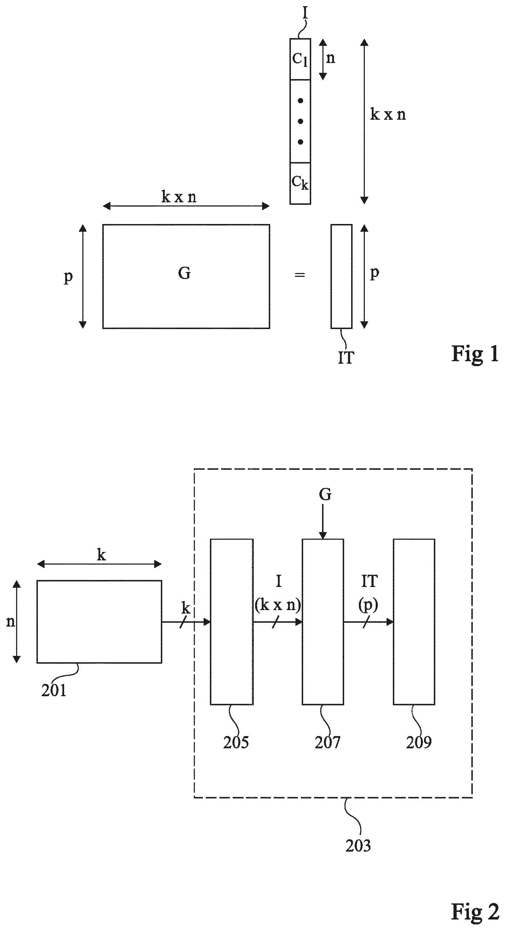

La figure 1 illustre schématiquement un exemple d'une opération de projection d'une image I fournie par un capteur d'images tel que défini ci-dessus, dans un domaine de représentation distinct du domaine d'acquisition.

L'image I est représentée sur la figure 1 sous la forme d'un vecteur colonne de $k*n$ valeurs, correspondant à la concaténation de k vecteurs colonnes $C_1$, ..., $C_k$, chaque vecteur $C_j$ (avec j entier allant de 1 à k) comportant n valeurs $C_j(1)$, ..., $C_j(n)$ correspondant respectivement aux valeurs de sortie des n pixels de la colonne de rang j du capteur (c'est-à-dire respectivement égales aux valeurs $L_1(j)$, ..., $L_n(j)$).

Dans l'exemple de la figure 1, la projection de l'image I dans un domaine de représentation adapté aux besoins d'une application spécifique consiste à multiplier le vecteur colonne I défini ci-dessus par une matrice de passage G de $k*n$ colonnes par p lignes, où p est un entier désignant la dimension de la projection ou transposée de l'image (c'est-à-dire du vecteur résultant de l'opération de projection de l'image).

Le résultat de cette multiplication est un vecteur IT de p valeurs correspondant à la projection de l'image I dans le domaine de représentation de dimension p défini par la matrice G.

La figure 2 est un schéma bloc d'un exemple d'un système d'acquisition comportant un capteur d'images 201 du type défini ci-dessus, et un dispositif de traitement 203 adapté à mettre en oeuvre l'opération décrite en relation avec la figure 1 de projection d'une image I fournie par le capteur, dans un domaine de représentation de dimension p défini par la matrice de passage G.

Dans cet exemple, le dispositif de traitement 203 comprend une mémoire 205 de dimension $k*n$, adaptée à mémoriser simultanément les $k*n$ valeurs des pixels de l'image I.

Lors d'une phase de lecture d'une image acquise par le capteur 201, les n vecteurs de sortie $L_1$, ..., $L_n$ successivement fournis par le capteur sont écrits dans la mémoire 203 de façon à construire l'image I.

Le dispositif de traitement 203 comprend en outre un étage 207 adapté à réaliser l'opération décrite ci-dessus de multiplication de l'image I de $k*n$ valeurs, par la matrice de passage G de $k*n*p$ valeurs, de façon à fournir le vecteur de sortie IT de dimension p, correspondant à la projection de l'image I dans le domaine de représentation défini par la matrice G.

Le dispositif de traitement 203 peut en outre comporter un bloc décisionnel 209 adapté à recevoir le vecteur IT de dimension p calculé par l'étage de multiplication 207, et à prendre une ou plusieurs décisions en fonction de la valeur du vecteur IT. A titre d'exemple, le bloc décisionnel 209 est adapté à classer l'image I dans une catégorie choisie parmi une pluralité de catégories prédéfinies, en fonction de la valeur du vecteur IT.

Un inconvénient du système de la figure 2 est que le dispositif de traitement 203 doit attendre que l'intégralité de l'image I acquise par le capteur ait été lue et écrite dans la mémoire 205 pour pouvoir commencer à effectuer les opérations de calcul de projection par l'intermédiaire de l'étage de multiplication 207. Le temps de lecture de l'image I acquise par le capteur est donc un temps perdu pendant lequel les opérations de calcul de projection ne sont pas mises en oeuvre.

En outre, dans le système de la figure 2, la mémoire 205 du dispositif de traitement 203 doit être relativement conséquente pour pouvoir contenir l'intégralité de l'image I acquise par le capteur.

De plus, le système de la figure 2 doit mémoriser l'ensemble des $n*k*p$ valeurs de la matrice de passage G, pour permettre à l'étage 207 de réaliser l'opération de multiplication matricielle $G*I$. Là encore, ceci nécessite des ressources mémoire importantes.

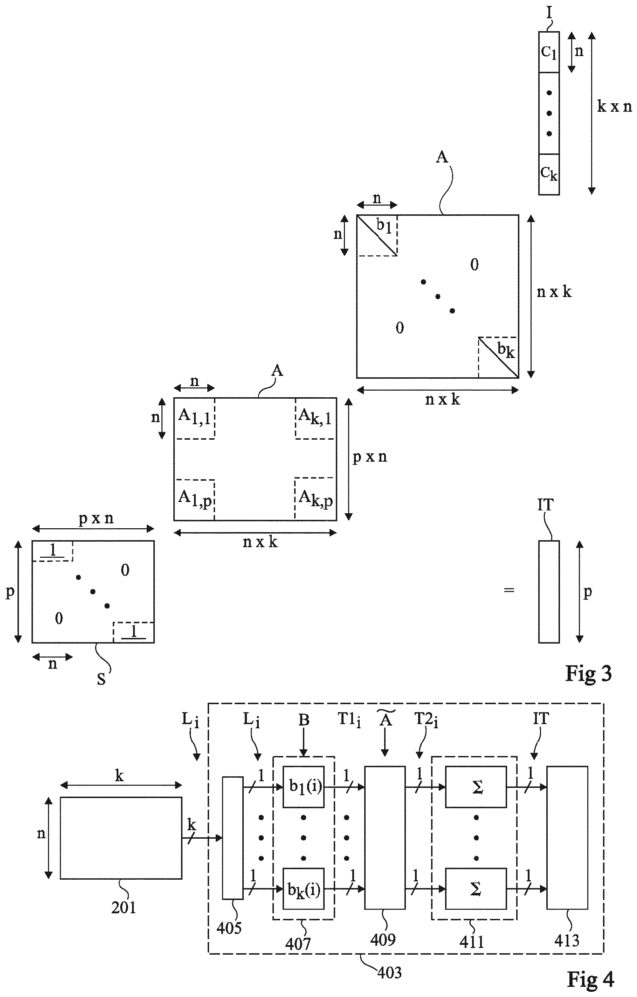

La figure 3 illustre schématiquement un exemple d'un mode de réalisation d'une opération de projection d'une image I fournie par un capteur d'images tel que défini ci-dessus, dans un domaine de représentation distinct du domaine d'acquisition.

Comme dans l'exemple de la figure 1, l'image I est représentée sur la figure 3 sous la forme d'un vecteur colonne de k*n valeurs correspondant à la concaténation des k vecteurs colonnes $C_1$, ... $C_k$ de dimension n de l'image I.

Dans l'exemple de la figure 3, l'opération de projection de l'image I dans un domaine de représentation de dimension p adapté aux besoins d'une application donnée, comprend la multiplication du vecteur colonne I par une première matrice carrée diagonale B de n*k lignes par n*k colonnes, et la multiplication du vecteur colonne de dimension n*k résultant de la multiplication B*I, par une deuxième matrice A de n*k colonnes par p*n lignes.

On désigne ici respectivement par $b_1$, ..., $b_k$, les k vecteurs de dimension n dont la concaténation forme le vecteur de dimension n*k constituant la diagonale de la matrice B. Autrement dit, le vecteur $b_1$ comprend les n premières valeurs de la diagonale de la matrice B, le vecteur $b_2$ comprend les n valeurs suivantes de la diagonale de la matrice B, et ainsi de suite jusqu'au vecteur $b_k$ qui comprend les n dernières valeurs de la diagonale de la matrice B.

La matrice A est constituée de p*k sous-matrices carrées $A_{j,l}$ de dimensions n*n disposées selon p lignes et k colonnes (où j, entier allant de 1 à k, désigne le rang de la colonne de la sous-matrice $A_{j,l}$, et où 1 est un entier allant de 1 à p désignant le rang de la ligne de la sous-matrice $A_{j,l}$). Une particularité de la matrice A est que chaque sous-matrice $A_{j,l}$ est une matrice diagonale dans laquelle les n valeurs de la diagonale de la matrice sont identiques, les valeurs des diagonales de sous matrices $A_{j,l}$ distinctes pouvant être différentes.

L'opération de projection de l'exemple de la figure 3 comprend en outre la multiplication du vecteur colonne de dimension p*n résultant de la multiplication A*B*I, par une matrice S de p lignes par p*n colonnes. La matrice S est constituée uniquement de '1' et de '0'. Plus particulièrement, chaque ligne de rang 1 de la matrice S, avec l entier allant de 1 à p, est constituée par un vecteur comprenant (l-1)*n '0' suivis de n '1' suivis de (p-l)*n '0'. Multiplier par la matrice S le vecteur colonne de dimension p*n résultant de la multiplication A*B*I, revient en fait à additionner, pour chacun des p sous-vecteurs consécutifs de dimension n formant ce vecteur colonne, les n valeurs du sous-vecteur. Le résultat de la multiplication S*A*B*I est un vecteur de sortie IT de p valeurs, correspondant à la projection de l'image I dans un domaine de représentation de dimension p défini par les matrices A et B.

En pratique, toute opération de projection IT= G*I telle que définie dans l'exemple des figures 1 et 2, peut être approximée par une opération de projection de type IT= S*A*B*I telle que définie en relation avec la figure 3. La détermination des matrices A et B permettant de réaliser l'opération de projection souhaitée ne sera pas décrite en détail, les matrices A et B pouvant être déterminées à partir des méthodes usuelles de détermination d'une matrice de passage qui soit discriminante entre des classes de signaux que l'on souhaite différencier, par exemple des méthodes basées sur un apprentissage à partir d'un ensemble d'images de référence préalablement acquises.

A titre d'exemple, les matrices A et B peuvent être déterminées directement par la résolution d'un problème de régularisation permettant de faire en sorte que l'opération de projection réalisée par le système soit la plus pertinente vis-à-vis d'une application spécifique. A titre d'exemple illustratif, on considère une application dans laquelle on souhaite classer (ou trier) des images I fournies par un capteur, en affectant à chaque image une catégorie (par exemple sous la forme d'un numéro) choisie parmi $n_c$ catégories prédéfinies, où $n_c$ est un entier supérieur à 1, en fonction de la valeur du vecteur de projection IT de l'image I. On considère en outre une base d'apprentissage préalablement constituée, comportant, pour chaque catégorie s, avec s entier allant de 1 à $n_c$, $n_s$ images $I_{s,rs}$ de la catégorie, où $n_s$ est un entier supérieur à 1, et rs est un entier allant de 1 à $n_s$ désignant le rang de l'image de catégorise s dans la base d'apprentissage. Dans ce cas, les matrices A et B peuvent être déterminées par la résolution d'un problème du type :

$$argmin_{A,B}\left(\left\|\hat{G}(A,B)M - Id\right\|_{Fro}^2 - \sum_s \frac{\lambda_s}{n_s}\sum_{rs}\left\|\hat{G}(A,B)\left(I_{s,rs} - M_s\right)\right\|_2^2\right)$$

Où $\hat{G}(A,B)$ est la matrice résultante telle que $\hat{G}(A,B) = S * A * B$, $M_s$ est une image moyennée correspondant à la moyenne des $n_s$ images $I_{s,rs}$ de la catégorie s, M est une image moyennée correspondant à la moyenne de l'ensemble des images $I_{s,rs}$ de la base d'apprentissage, Id est la matrice identité, et $\lambda_s$ est un coefficient de régularisation qui peut être réglé différemment pour chaque catégorie.

A titre de variante, les matrices A et B peuvent être déterminées de façon que la matrice résultante $\hat{G}(A,B)$ approxime au plus près une matrice de référence G correspondant à l'opération de projection que l'on vise à réaliser, selon des critères d'approximation prédéfinis. A titre d'exemple, on peut vouloir minimiser la norme Froebenius entre la matrice $\hat{G}(A,B)$ et la matrice G en résolvant un problème de minimisation de type :

$$argmin_{A,B} \left\| \hat{G}(A,B) - G \right\|^2_{Fro},$$

où $\| \; \|_{Fro}$ désigne la norme de Froebenius.

Plus généralement, toute autre méthode de détermination des matrices A et B peut être utilisée.

La figure 4 est un schéma bloc d'un exemple d'un mode de réalisation d'un système électronique d'acquisition, comportant un capteur d'images 201 du type défini ci-dessus, et un dispositif électronique de traitement 403 adapté à mettre en oeuvre l'opération décrite en relation avec la figure 3 de projection d'une image I fournie par le capteur, dans un domaine de représentation de dimension p défini par les matrices de passage A et B.

Dans cet exemple, le dispositif de traitement 403 comprend une mémoire 405 de dimension k, adaptée à mémoriser simultanément les k valeurs de sortie des pixels d'une même ligne de l'image I.

Lors d'une phase de lecture d'une image acquise par le capteur 201, les n lignes du capteur sont successivement lues. A chaque lecture d'une ligne de rang i du capteur, le vecteur $L_i$ des valeurs de sortie des pixels de la ligne, c'est-à-dire le vecteur de dimension k constitué par les valeurs $C_1(i)$, ..., $C_k(i)$, est écrit dans la mémoire 405.

Le dispositif de traitement 403 comprend de plus un étage 407 adapté, à chaque lecture d'une ligne de rang i du capteur et avant la lecture de la ligne suivante, à multiplier les k valeurs $C_1(i)$, ... $C_k(i)$ du vecteur $L_i$ stockées dans la mémoire 405, respectivement par les k coefficients $b_1(i)$, ..., $b_k(i)$ de la diagonale de la matrice B. L'étage 407 comprend par exemple k circuits multiplieurs réalisant simultanément les k multiplications $C_1(i)*b_1(i)$, ..., $C_k(i)*b_k(i)$. Ainsi, à chaque lecture d'une ligne de rang i du capteur et avant que la ligne suivante soit lue, l'étage 407 réalise k multiplications parmi les n*k multiplications que comprend l'opération de multiplication matricielle I*B de la figure 3. On note ici $T1_i$ le vecteur de dimension k fourni par l'étage 407, constitué par les valeurs $C_1(i)*b_1(i)$, ..., $C_k(i)*b_k(i)$.

Le dispositif de traitement 403 comprend en outre un étage 409 adapté à recevoir le vecteur $T1_i$ de dimension k fourni par l'étage 407 à chaque lecture d'une ligne de rang i du capteur, et à multiplier ce vecteur par une matrice Ã de p lignes par k colonnes, comprenant respectivement les p*k coefficients définissant la matrice A. Autrement dit, la matrice Ã comprend p*k coefficients $a_{j,l}$ disposés selon p lignes et k colonnes (où j désigne le rang de la colonne du coefficient $a_{j,l}$, et où l désigne le rang de la ligne du coefficient $a_{j,l}$), chaque coefficient $a_{j,l}$ étant égal à la valeur du coefficient unique de la sous matrice $A_{j,l}$ de même coordonnées dans la matrice A. Ainsi, à chaque fois qu'un vecteur $T1_i$ est fourni par l'étage 407, et avant la fourniture du vecteur $T1_i$ suivant, l'étage 409 réalise k*p multiplications parmi les n*k*p multiplications que comprend, dans l'exemple de la figure 3, l'opération de multiplication du vecteur résultant du produit I*B par la matrice A. On note ici $T2_i$ le vecteur de dimension p fourni par l'étage 409, résultant de la multiplication du vecteur $T1_i$ par la matrice Ã.

Le dispositif de traitement 403 comprend en outre un étage 411 d'intégration des n vecteurs $T2_i$ successivement fournis par l'étage 409 lors des n lectures successives des lignes du capteur. L'étage d'intégration 411 est par exemple réinitialisé uniquement entre deux phases successives de lecture de l'intégralité d'une image I acquise par le capteur. Ainsi, à la fin d'une phase de lecture du capteur (c'est-à-dire après la lecture de la ligne de rang n du capteur), l'étage 411 fournit un vecteur de sortie IT de dimension p, dont chaque coefficient IT(l), avec l entier allant de 1 à p, est égal à la somme des coefficients de rang l $T2_1(l)$, ... $T2_n(l)$ successivement fournis par l'étage 409. Le vecteur IT correspond à la projection de l'image I dans le domaine de représentation de dimension p défini par les matrices A et B. L'étage 411 réalise ainsi l'opération de sommation correspondant, dans la représentation de la figure 3, à la multiplication par la matrice S du résultat du produit A*B*I.

Le dispositif de traitement 403 peut en outre comporter un bloc décisionnel 413 adapté à recevoir le vecteur IT de dimension p fourni par l'étage d'intégration 411 à la fin d'une phase de lecture d'une image acquise par le capteur, et à prendre une ou plusieurs décisions en fonction de la valeur du vecteur IT. A titre d'exemple, le bloc décisionnel 413 est adapté à classer l'image I dans une catégorie choisie parmi une pluralité de catégories prédéfinies, en fonction de la valeur du vecteur IT.

Un avantage du système de la figure 4 est que le dispositif de traitement 403 n'a pas besoin d'attendre que l'intégralité de l'image I acquise par le capteur ait été lue pour pouvoir commencer à mettre en oeuvre les opérations de calcul de projection. Ceci permet un gain de temps dans la mesure où le calcul de la projection de l'image I dans un domaine de représentation distinct du domaine d'acquisition est effectué en parallèle de la lecture de l'image.

En outre, ceci permet une économie de ressources mémoires, dans la mesure où il n'est plus nécessaire de stocker l'intégralité de l'image acquise par le capteur avant de commencer le calcul. En particulier, dans l'exemple de la figure 4, la mémoire 405 est réduite à la dimension d'une ligne du capteur, soit une capacité de stockage de k valeurs. En comparaison, la mémoire 205 du dispositif de traitement 203 de la figure 2 doit avoir une capacité de stockage de n*k valeurs. A titre de variante, dans le mode de réalisation de la figure 4, la mémoire 405 peut être omise. Dans ce cas, à chaque lecture d'une ligne $L_i$ du capteur, le vecteur $L_i$ est directement transmis à l'étage de multiplication 407.

Un autre avantage du système de la figure 4 est que la mémorisation des coefficients des matrices A et B nécessite des ressources mémoires réduites par rapport à la mémorisation des coefficients de la matrice G dans le système de la figure 2. Plus particulièrement, dans le système de la figure 4, la mémorisation de la matrice A requiert le stockage de p*k coefficients, et la mémorisation de la matrice B requiert le stockage de k*n coefficients. A titre de comparaison, la mémorisation de la matrice G dans le système de la figure 2 requiert le stockage de n*k*p coefficients.

A titre d'exemple, les étages 407, 409 et 411 sont cascadés et sont cadencés par un même signal d'horloge, de façon que chaque étage réalise l'opération de calcul qui lui est attribuée entre deux fronts montants ou descendants consécutifs du signal d'horloge.

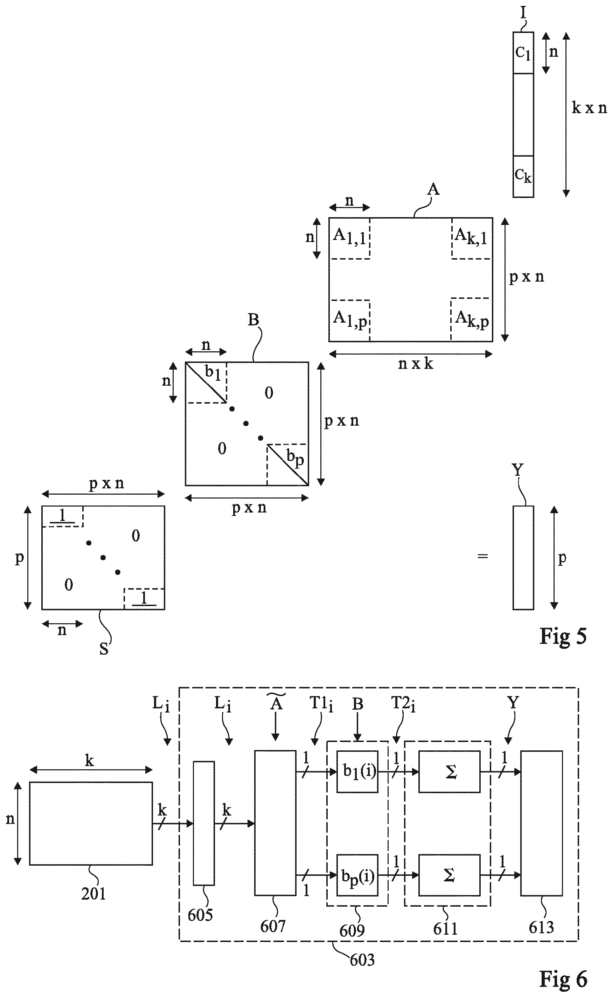

La figure 5 illustre schématiquement un autre exemple d'un mode de réalisation d'une opération de projection d'une image I fournie par un capteur d'images tel que défini ci-dessus, dans un domaine de représentation distinct du domaine d'acquisition.

Comme dans les exemples des figures 1 et 3, l'image I est représentée sur la figure 5 sous la forme d'un vecteur colonne de k*n valeurs correspondant à la concaténation des k vecteurs colonnes $C_1$, ..., $C_k$ de dimension n de l'image I.

Dans l'exemple de la figure 5, l'opération de projection de l'image I dans un domaine de représentation de dimension p adapté aux besoins d'une application donnée, comprend la multiplication du vecteur colonne I par une première matrice A de n*k colonnes par p*n lignes, et la multiplication du vecteur colonne de dimension p*n résultant de la multiplication A*I, par une deuxième matrice B de p*n colonnes par p*n lignes.

La matrice B est une matrice carrée diagonale. On désigne ici respectivement par $b_1$, ..., $b_p$, les p vecteurs de dimension n dont la concaténation forme le vecteur de dimension n*p constituant la diagonale de la matrice B. Autrement dit, le vecteur $b_1$ comprend les n premières valeurs de la diagonale de la matrice B, le vecteur $b_2$ comprend les n valeurs suivantes de la diagonale de la matrice B, et ainsi de suite jusqu'au vecteur $b_p$ qui comprend les n dernières valeurs de la diagonale de la matrice B.

La matrice A est constituée de p*k sous-matrices carrées $A_{j,l}$ de dimensions n*n disposées selon p lignes et k colonnes (où j désigne le rang de la colonne de la sous-matrice $A_{j,l}$, et où l désigne le rang de la ligne de la sous-matrice $A_{j,l}$). Comme dans le mode de réalisation de la figure 3, une particularité de la matrice A est que chaque sous matrice $A_{j,l}$ est une matrice diagonale dans laquelle les n valeurs de la diagonale sont identiques, les valeurs des diagonales de sous matrices $A_{j,l}$ distinctes pouvant être différentes.

L'opération de projection de l'exemple de la figure 5 comprend en outre la multiplication du vecteur colonne de dimension p*n résultant de la multiplication B*A*I, par une matrice S de p lignes par p*n colonnes, identique ou similaire à la matrice S de la figure 3. Le résultat de la multiplication S*B*A*I est un vecteur de sortie IT de p valeurs, correspondant à la projection de l'image I dans un domaine de représentation de dimension p défini par les matrices A et B.

En pratique, toute opération de projection IT= G*I telle que définie dans l'exemple des figures 1 et 2, peut être approximée par une opération de projection de type IT= S*B*A*I telle que définie en relation avec la figure 5. La détermination des matrices A et B permettant de réaliser l'opération de projection souhaitée peut être réalisée par des méthodes similaires à celles décrites ci-dessus en relation avec la figure 3, ou par toute autre méthode adaptée.

La figure 6 est un schéma bloc d'un exemple d'un mode de réalisation d'un système électronique d'acquisition comportant un capteur d'images 201 du type défini ci-dessus, et un dispositif électronique de traitement 603 adapté à mettre en oeuvre l'opération décrite en relation avec la figure 5 de projection d'une image I fournie par le capteur dans un domaine de représentation de dimension p défini par les matrices de passage A et B.

Dans cet exemple, le dispositif de traitement 603 comprend une mémoire 605 de dimension k, adaptée à mémoriser simultanément les k valeurs de sortie des pixels d'une même ligne de l'image I.

Lors d'une phase de lecture d'une image acquise par le capteur 201, les n lignes du capteur sont successivement lues. A chaque lecture d'une ligne de rang i du capteur, le vecteur $L_i$ des valeurs de sortie des pixels de la ligne, c'est-à-dire le vecteur de dimension k constitué par les valeurs $C_1(i)$, ..., $C_k(i)$, est écrit dans la mémoire 605.

Le dispositif de traitement 603 comprend de plus un étage 607 adapté, à chaque lecture d'une ligne de rang i du capteur et avant la lecture de la ligne suivante, à multiplier le vecteur $L_i$ stocké dans la mémoire 605, par une matrice Ã de p lignes par k colonnes comprenant respectivement les p*k coefficients définissant la matrice A. Ainsi, à chaque lecture d'une ligne de rang i du capteur et avant que la ligne suivante soit lue, l'étage 607 réalise k*p multiplications parmi les n*k*p multiplications que comprend, dans l'exemple de la figure 5, l'opération de multiplication I*A. On note ici $T1_i$ le vecteur de dimension p fourni par l'étage 607, résultant de la multiplication du vecteur $L_i$ par la matrice Ã.

Le dispositif de traitement 603 comprend en outre un étage 609 adapté à recevoir le vecteur $T1_i$ de dimension p fourni par l'étage 607 à chaque lecture d'une ligne de rang i du capteur, et à multiplier les p coefficients de ce vecteur respectivement par les p coefficients $b_1(i)$, ..., $b_p(i)$ de la diagonale de la matrice B. L'étage 609 comprend par exemple p circuits multiplieurs réalisant simultanément les p multiplications $T1_i(1)*b_1(i)$, ..., $T1_i(p)*b_p(i)$. Ainsi, à chaque lecture d'une ligne de rang i du capteur et avant que la ligne suivante soit lue, l'étage 609 réalise p multiplications parmi les n*p multiplications que comprend, dans l'exemple de la figure 5, l'opération de multiplication du vecteur résultant du produit A*I par la matrice B. On note ici $T2_i$ le vecteur de dimension p fourni par l'étage 609, constitué par les valeurs $T1_i(1)*b_1(i)$, ..., $T1_i(p)*b_p(i)$.

Le dispositif de traitement 603 comprend en outre un étage 611 d'intégration des n vecteurs $T2_i$ successivement fournis par l'étage 609 lors des n lectures successives des lignes du capteur. L'étage d'intégration 611 est par exemple réinitialisé uniquement entre deux phases de lectures successives d'une image I acquise par le capteur. Ainsi, à la fin d'une phase de lecture du capteur (c'est-à-dire après la lecture de la ligne de rang n du capteur), l'étage 611 fournit un vecteur de sortie IT de dimension p, dont chaque coefficient IT(l), avec l entier allant de 1 à p, est égal à la somme des coefficients de rang 1 $T2_1(l)$, ..., $T2_n(l)$ successivement fournis par l'étage 609. Le vecteur IT correspond à la projection de l'image I dans le domaine de représentation défini par les matrices A et B. L'étage 611 réalise ainsi l'opération de sommation correspondant, dans la représentation de la figure 5, à la multiplication par la matrice S du résultat du produit B*A*I.

Le dispositif de traitement 603 peut en outre comporter un bloc décisionnel 613 adapté à recevoir le vecteur IT de dimension p fourni par l'étage d'intégration 611 à la fin d'une phase de lecture d'une image acquise par le capteur, et à prendre une ou plusieurs décisions en fonction de la valeur du vecteur IT. A titre d'exemple, le bloc décisionnel 613 est adapté à classer l'image I dans une catégorie choisie parmi une pluralité de catégories prédéfinies, en fonction de la valeur du vecteur IT.

A titre de variante, dans l'exemple de la figure 6, la mémoire 605 peut être omise. Dans ce cas, à chaque lecture d'une ligne $L_i$ du capteur, le vecteur $L_i$ est directement transmis à l'étage de multiplication 607.

Le système de la figure 6 est une alternative au système de la figure 4, présentant sensiblement les mêmes avantages que le système de la figure 4 par rapport au système de la figure 2. Une différence entre le système de la figure 6 et le système de la figure 4 est que, dans le système de la figure 6, le nombre de multiplications réalisé pour calculer la projection de l'image I est de n*p(k+1), contre n*k(1+p) dans le système de la figure 4. De plus, la mémorisation des coefficients des matrices A et B dans le système de la figure 6 requiert le stockage de p*k+p*n valeurs, contre p*k+k*n valeurs dans le système de la figure 4. Selon les valeurs des nombres p et k, l'homme du métier saura choisir le système le plus avantageux pour minimiser le besoin en mémoire et/ou la complexité de calcul.

Comme indiqué précédemment, les coefficients des matrices A et B sont mémorisés dans une mémoire, non représentée en figures 4 et 6, mais faisant partie du dispositif de traitement 403 ou 603. Dans un mode « d'utilisation » du dispositif de traitement tel que décrit précédemment, les coefficients des matrices A et B ne changent pas. Néanmoins, sauf dans des cas très particuliers où il est possible de définir analytiquement les coefficients des matrices A et B, dans la majorité des cas les coefficients ont été obtenus après mise en œuvre d'un procédé d'apprentissage, par exemple selon une résolution de problème du type décrit précédemment, par exemple du type :

$$ argmin_{A,B} \left( \left\| \hat{G}(A,B)M - Id \right\|_{Fro}^2 - \sum_s \frac{\lambda_s}{n_s} \sum_{rs} \left\| \hat{G}(A,B)\left(I_{s,rs} - M_s\right) \right\|_2^2 \right) $$

Ainsi, selon un mode de réalisation avantageux de la présente invention, le système électronique peut comprendre en outre un dispositif électronique d'apprentissage « embarqué » comprenant :

- une mémoire « de référence » stockant (temporairement ou non) au moins une valeur de référence (par exemple une matrice G de référence ou au moins un couple de valeurs d'entrée/sortie de référence, chaque couple incluant un vecteur de référence I et un vecteur de référence IT associé attendu) ;
- un dispositif de calcul d'optimum (utilisant par exemple un processeur) apte à rechercher des coefficients des matrices A et B permettant de s'approcher au mieux de ladite au moins une valeur de référence ; et
- un dispositif d'écriture des coefficients des matrices A et B dans la mémoire de stockage du dispositif de traitement (403, 603), les valeurs mémorisées pouvant être modifiées pendant le processus d'apprentissage, sur requête du dispositif de calcul d'optimum.

Le dispositif électronique d'apprentissage embarqué est activé préalablement à l'utilisation du système électronique, mais peut également être activé entre deux utilisations du système électronique, par exemple pour mettre en œuvre un apprentissage continu des matrices A et B.

Un avantage d'un dispositif électronique incluant des matrices A et B apprises lors d'un processus d'apprentissage préalable (réalisé par un dispositif d'apprentissage embarqué ou externe) et répondant aux définitions susmentionnées **($\hat{G}(A,B) = S * A * B$)** est qu'il permet de réaliser un traitement potentiellement aussi précis qu'un dispositif de l'état de l'art (figure 1 avec la mémorisation d'une matrice G complète) mais de façon plus rapide et avec un besoin moindre de ressource mémoire. C'est notamment le cas pour les applications de type classification ou pour le calcul d'un ou plusieurs paramètres selon une méthode de régression (par exemple pour calculer simultanément différentes valeurs d'un paramètre physique selon sa propre échelle). On pourra avantageusement utiliser une méthode d'apprentissage de type SVM pour « machine à vecteur de support » qui permet de réaliser une tâche de classification avec une prise de décision simplifiée, par seuillages, sur la base du vecteur IT (par exemple une méthode équivalente à une SVM linéaire multi-classes avec une construction du type « one versus all »).

On notera que l'utilisation des matrices A et B avec un processus d'apprentissage préalable n'a pas vocation à servir uniquement à compresser la taille des données issues du capteur, mais à transformer ces données d'entrée en données de sortie d'une autre nature pour permettre de réaliser au moins en partie un traitement de ces données en vue d'une prise de décision ultérieure (commande d'un actionneur, alarme, détection, mesures...). L'utilisation de ces données de sortie (IT) peut être immédiate (si le bloc 209 est relié à un dispositif électronique répondant/traitant ces données à la volée) ou différée (si le bloc 209 est relié à un dispositif d'écriture en mémoire des données en vue d'une utilisation ultérieure). Dans les deux cas, les données de sortie IT sont « confiées » à un autre dispositif du système électronique pour leur mémorisation ou leur utilisation immédiate.

On notera que dans les exemples décrits ci-dessus, chacun des nombres n et k est de préférence supérieur ou égal à 2. A titre de variante, le nombre n est supérieur ou égal à 2 et le nombre k est égal à 1. Le nombre p est de préférence inférieur au produit n*k, de façon que l'opération de projection réalisée soit aussi une opération de réduction de dimensions, ce qui permet de réduire la complexité d'éventuels traitements ultérieurs, ainsi que les besoins en mémoire et en ressources énergétiques pour la mise en oeuvre de ces traitements ultérieurs.

Les exemples décrits ci-dessus concernent des systèmes d'acquisition d'images comportant des capteurs d'images classiques, dans lesquels les valeurs d'intensités lumineuses mesurées par le capteur et évacuées de façon séquentielle sont des valeurs numériques quantifiées sur plusieurs bits. A titre de variante, les modes de réalisation des figures 4 et 6 peuvent être adaptés à un capteur d'image fournissant, à chaque lecture d'une ligne $L_i$, des valeurs de pixels quantifiées sur un seul bit, chaque pixel du capteur étant lu successivement une pluralité de fois pour construire une valeur de pixel quantifiée sur plusieurs bits. Un exemple d'un tel capteur d'images est décrit dans la demande de brevet FR N °16/60627 déposée par le demandeur le 3 novembre 2016. Dans ce cas, chaque image binaire fournie par le capteur peut être projetée à la volée par un dispositif de traitement 403 ou 603 du type décrit ci-dessus, les projections des images binaires successives étant ensuite additionnées pour construire une image projetée finale.

Les modes de réalisation décrits s'appliquent plus généralement à tout système comportant un capteur adapté à évacuer des données mesurées de façon séquentielle, et dans lequel on souhaite pouvoir calculer un descripteur (le vecteur IT dans les exemples ci-dessus) d'un ensemble de valeurs mesurées par le capteur (l'image I dans les exemples ci-dessus) en vue d'effectuer par exemple des opérations de classification.

Un exemple d'application à l'imagerie multi-spectrale va maintenant être décrit, dans lequel le capteur du système d'acquisition est adapté à générer à la volée une pluralité d'histogrammes d'une scène, correspondant respectivement à des bandes de longueurs d'ondes ou bandes spectrales distinctes de la scène.

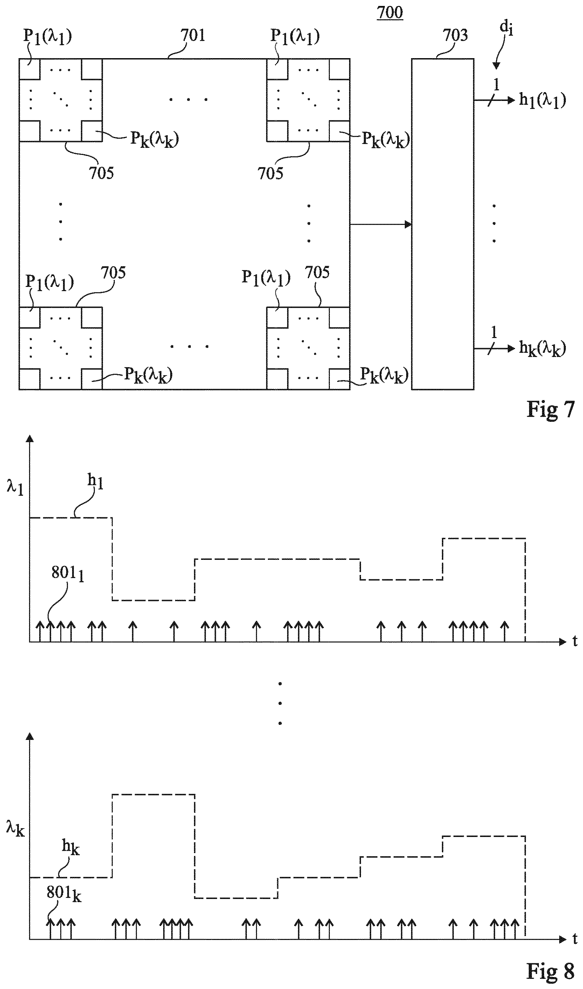

La figure 7 représente de façon schématique un capteur de données 700 comprenant un capteur photosensible multi-spectral asynchrone 701, et un circuit de construction d'histogramme 703 dont une entrée est reliée à une sortie du capteur 701.

Le capteur 701 comprend une pluralité de pixels, par exemple agencés en matrice selon des lignes et des colonnes. Dans cet exemple, le capteur 701 est divisé en plusieurs sous-ensembles de pixels 705. Les sous-ensembles de pixels 705 sont par exemple identiques ou similaires. A titre d'exemple, les sous-ensembles de pixels 705 sont régulièrement répartis sur toute la surface du capteur. Dans cet exemple, chaque sous-ensemble de pixels 705 comprend k pixels $P_1$, ..., $P_k$, respectivement adaptés à mesurer des intensités lumineuses reçues dans k bandes spectrales $\lambda_1$, ..., $\lambda_k$ distinctes. Pour cela, chaque pixel $P_j$, avec j entier allant de 1 à k, comprend par exemple un filtre optique spécifique ne transmettant à un photorécepteur du pixel qu'une bande spectrale spécifique, différente des bandes spectrales transmises par les filtres optiques des autres pixels du sous-ensemble.

Par capteur asynchrone, on entend ici que les données mesurées par le capteur sont évacuées de façon asynchrone, et non selon une séquence de lecture prédéfinie. Plus particulièrement, dans cet exemple, chaque pixel est adapté à intégrer, par exemple dans un élément capacitif du pixel, un signal électrique représentatif d'une intensité lumineuse reçue par le pixel dans sa bande spectrale de sensibilité depuis un instant de début d'une phase d'intégration du capteur, et à émettre un signal d'indication d'allumage sur une piste conductrice de sortie du capteur lorsque le signal intégré par le pixel dépasse un seuil (on dit que le pixel s'allume lorsque la quantité d'énergie lumineuse reçue par le pixel dans sa bande spectrale de sensibilité depuis le début de l'intégration dépasse un seuil). Le signal de sortie du capteur est ainsi constitué par une suite de signaux d'indication d'allumage, par exemple des signaux impulsionnels. A titre d'exemple, les signaux d'indication d'allumage émis par les pixels sont tous identiques (par exemple en forme d'impulsion de Dirac), mais les signaux d'indication d'allumage émis par des pixels de sensibilités spectrales distinctes sont émis sur des pistes conductrices de sortie distinctes du capteur, ce qui permet de discriminer les différentes bandes spectrales en sortie du capteur. A titre de variante, les signaux d'indication d'allumage sont tous émis sur une même piste conductrice de sortie du capteur, mais les signaux d'indication d'allumage émis par des pixels de sensibilités spectrales différentes ont des caractéristiques différentes, par exemple des formes différentes, de façon à pouvoir discriminer les différentes bandes spectrales en sortie du capteur.

Le circuit 703 est adapté à recevoir les signaux d'indication d'allumage fournis par le capteur 701, et à compter, dans des intervalles de temps prédéfinis définissant des classes d'histogrammes, le nombre de signaux d'indication d'allumage émis par le capteur pour chacune des bandes spectrales de sensibilité du capteur. Le circuit 703 construit ainsi k histogrammes $h_1$, ..., $h_k$ de la scène, correspondant respectivement aux k bandes spectrales $\lambda_1$, ..., $\lambda_k$ de sensibilité du capteur.

La figure 8 est un chronogramme illustrant de façon schématique les données fournies par le capteur 701 et par le circuit de construction d'histogramme 703 de la figure 7. La figure 8 représente plus particulièrement l'évolution, en fonction du temps, pour chaque bande spectrale de sensibilité $\lambda_j$ du capteur 701, des signaux d'indication d'allumage $801_j$ (représentés par des flèches verticales sur la figure) émis par les pixels $P_j$ du capteur 701, et du signal d'histogramme $h_j$ (en traits interrompus) fourni par le circuit 703.

On notera que bien que le capteur 701 soit asynchrone, le circuit de construction d'histogramme 703 présente un fonctionnement synchrone. Plus particulièrement, les signaux de sortie du circuit 703 sont des signaux synchrones.

On considère ici que les k histogrammes $h_1$, ... $h_k$ construits par le circuit 703 présentent tous un même nombre n de classes, et que les classes de même rang i (avec i entier allant de 1 à n) des différents histogrammes sont de même largeur. La largeur des classes des histogrammes peut être constante ou variable en fonction du temps (c'est-à-dire en fonction de leur rang i).

Ainsi, le circuit 703 fournit successivement n vecteurs $d_i$ de dimensions k, chaque vecteur $d_i$ étant constitué par la suite des valeurs $h_1(i)$, ..., $h_k(i)$ des classes de rang i des k histogrammes $h_1$, ..., $h_k$.

Le capteur 700 forme ainsi un capteur d'histogrammes adapté à générer à la volée une pluralité d'histogrammes d'une scène correspondant respectivement à des bandes spectrales distinctes de la scène, ce capteur évacuant de façon séquentielle les données d'histogrammes mesurées.

Un dispositif de traitement du type décrit ci-dessus en relation avec les figures 3, 4, 5 et 6 peut être couplé au capteur 700, de façon à projeter l'ensemble des données d'histogrammes acquises par le capteur, dans un domaine de représentation spécifique adapté, par exemple, à la mise en oeuvre d'opérations de classification. Pour cela, on peut par exemple remplacer le capteur 201 des figures 4 et 6 par le capteur d'histogramme 700 de la figure 7, et, dans les représentations des figures 3 à 6, les vecteurs $C_1$, ..., $C_k$ de dimension n par respectivement les vecteurs $h_1$, ..., $h_k$ de dimension n, et les vecteurs $L_1$, **...,** $L_n$ de dimension k par respectivement les vecteurs $d_1$, ..., $d_n$ de dimension k.

A titre de variante, le système d'acquisition ainsi obtenu peut être adapté au cas où k = 1, c'est-à-dire au cas d'un capteur photosensible asynchrone présentant une unique bande spectrale de sensibilité.

Par ailleurs, l'application décrite ci-dessus en relation avec les figures 7 et 8 peut être adaptée au cas où, pour chaque bande de sensibilité spectrale $\lambda_j$ du capteur 701, le circuit de construction d'histogramme construit non pas un seul histogramme $h_j$, mais une pluralité d'histogrammes d'échelles différentes, c'est-à-dire présentant des largeurs de classes différentes.

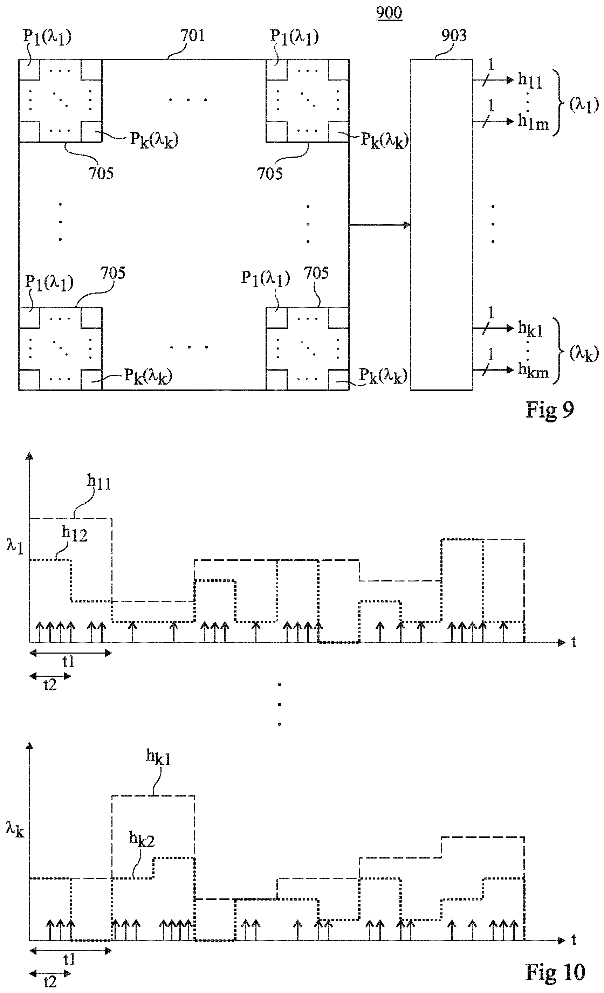

Cette configuration est représentée de façon schématique sur les figures 9 et 10.

La figure 9 représente de façon schématique un capteur de données 900 qui diffère du capteur 700 de la figure 7 en ce que, dans l'exemple de la figure 9, le circuit de construction d'histogrammes 703 est remplacé par un circuit de construction d'histogrammes 903 fournissant, pour chaque bande spectrale $\lambda_j$, m histogrammes $h_{j1}$, ..., $h_{jm}$ (où m est un entier supérieur ou égal à 2) d'échelles distinctes.

La figure 10 est un chronogramme illustrant de façon schématique les données fournies par le capteur 701 et par le circuit de construction d'histogramme 903 de la figure 9. La figure 10 représente en particulier, pour chaque bande spectrale de sensibilité $\lambda_j$ du capteur 701, les signaux d'indication d'allumage $801_j$ (représentés par des flèches verticales sur la figure) émis par les pixels $P_j$ du capteur. La figure 10 représente en outre, pour chaque bande spectrale $\lambda_j$, deux histogrammes $h_{j1}$ et $h_{j2}$ (m = 2 dans cet exemple), respectivement en traits interrompus et en pointillés, générés par le circuit 903. Comme cela apparaît sur la figure, les histogrammes $h_{i1}$ et $h_{i2}$ présentent des largeurs de classes (ou échelles) différentes. Autrement dit, pour chaque bande spectrale $\lambda_j$, l'intervalle t1 de temps pendant lequel le circuit 903 compte les signaux d'indication d'allumage émis par les pixels $P_j$ pour fournir une valeur de l'histogramme $h_{j1}$ est différent de l'intervalle de temps t2 pendant lequel le circuit 903 compte les signaux d'indication d'allumage émis par les pixels $P_j$ pour fournir une valeur de l'histogramme $h_{j2}$.

On considère ici que pour chaque indice u entier allant de 1 à m, les k histogrammes $h_{1u}$, ... $h_{ku}$ construits par le circuit 903 présentent tous un même nombre entier $n_u$ de classes, et que les classes de même rang $i_u$ (avec $i_u$ entier allant de 1 à $n_u$) des différents histogrammes de rang u sont de même largeur. La largeur des classes des histogrammes $h_{1u}$, ..., $h_{ku}$ peut être constante ou variable en fonction du temps (c'est-à-dire en fonction de leur rang $i_u$).

Le circuit 903 fournit ainsi successivement, pour chaque indice u allant de 1 à m, $n_u$ vecteurs $d_{iu}$ de dimension k, chaque vecteur $d_{iu}$ étant constitué par la suite des valeurs $h_{1u}(i_u)$, ..., $h_{ku}(i_u)$ des classes de rang $i_u$ des k histogrammes $h_{1u}$, ..., $h_{ku}$.

Le capteur 900 forme ainsi un capteur d'histogrammes adapté à générer à la volée une pluralité d'histogrammes multi-échelles d'une scène correspondant respectivement à des bandes spectrales distinctes de la scène, ce capteur évacuant de façon séquentielle les données d'histogrammes mesurées.

m dispositifs de traitement du type décrit ci-dessus en relation avec les figures 3, 4, 5 et 6 peuvent être couplés au capteur 900 de façon à projeter à la volée, pour chaque échelle d'histogramme d'indice u, l'ensemble des données d'histogrammes acquises par le capteur dans un domaine de représentation adapté, par exemple, à la réalisation d'opérations de classification. A titre d'exemple, on peut coupler, à la sortie du capteur d'histogrammes 900 de la figure 9, m circuits de traitement $403_u$ ou $603_u$ similaires aux circuits de traitement 403 ou 603 décrits ci-dessus, en remplaçant, pour chaque dispositif de traitement d'indice u, les vecteurs $C_1$, ... $C_k$ de dimension n (en considérant les notations utilisées en relation avec les figures 4 à 6), respectivement par les vecteurs $h_{1u}$, ..., $h_{ku}$ de dimension $n_u$ (en considérant les notations utilisées en relation avec les figures 9 et 10), et les vecteurs $L_1$, ... $L_n$ de dimension k (en considérant les notations utilisées en relation avec les figures 4 à 6), respectivement par les vecteurs $d_{1u}$, ... $d_{nu}$ de dimension k (en considérant les notations utilisées en relation avec les figures 9 et 10).

A titre de variante, le système d'acquisition ainsi obtenu peut être adapté au cas où k = 1, c'est-à-dire au cas d'un capteur d'histogramme multi-échelles présentant une unique bande spectrale de sensibilité.

Des modes de réalisation particuliers ont été décrits. Diverses variantes et modifications apparaîtront à l'homme de l'art. En particulier, les modes de réalisation décrits ne se limitent pas aux exemples d'application décrits ci-dessus, mais peuvent s'appliquer plus généralement à tout système d'acquisition comportant un capteur adapté à évacuer de façon séquentielle des données mesurées, dans lequel on souhaite pouvoir calculer à la volée une projection d'un ensemble de mesures fournies par le capteur dans un domaine de représentation distinct du domaine d'acquisition, par exemple en vue de réaliser des opérations de classification.

Un exemple d'application en classification hyperspectrale peut consister à découper un capteur d'images hyperspectrales de x*y pixels et z bandes spectrales, x, y et z étant des entiers supérieurs à 1, en u sous-ensembles de v*w pixels et z bandes spectrales (avec u, v et w entiers supérieurs à 1 tels que x=u*v et y=u*w). Chaque sous-ensemble peut être associé à un circuit de lecture et à un dispositif de traitement du type décrit ci-dessus. A l'issue d'une phase d'acquisition, chaque sous-ensemble de pixels se voit attribuer une catégorie choisie parmi un ensemble de plusieurs catégories, en fonction de la valeur d'un descripteur calculé à partir des données d'histogrammes hyperspectrales du sous-ensemble. Un tel système peut par exemple être utilisé pour traiter de façon automatique des images satellite ou aériennes de façon à discriminer les différentes catégories d'éléments (route, foret, eau, construction, etc.) susceptibles de constituer une scène, par exemple pour des applications de cartographie.

## Revendications

1. Système électronique comportant :

   un capteur (201 ; 700 ; 900) adapté à fournir successivement n vecteurs $L_i$ comportant chacun k valeurs mesurées $L_i(j)$, où n et k sont des entiers avec n ≥ 2 et k ≥ 1, i est un entier allant de 1 à n, et j est un entier allant de 1 à k ; et
   un dispositif électronique (403) de traitement à la volée des valeurs mesurées par le capteur adapté à fournir une projection $\check{G}(A,B)*I$, dans un domaine de représentation de dimension p, de l'ensemble des n*k valeurs $L_i(j)$ mesurées par le capteur, p étant un entier avec p ≥ 1, I étant un vecteur colonne de n*k valeurs, constitué par l'ensemble des n*k valeurs $L_i(j)$ mesurées par le capteur, et G(A,B) étant une matrice de projection de p lignes et n*k colonnes telle que $\check{G}(A,B)=S*A*B$, où B est une matrice carrée diagonale de n*k lignes par n*k colonnes, et A est une matrice de n*k colonnes par p*n lignes constituée de p*k sous-matrices carrées de dimensions n*n disposées selon p lignes et k colonnes, chaque sous-matrice carrée étant une matrice diagonale dont les n valeurs de la diagonale sont identiques, et où S est une matrice de p lignes par p*n colonnes dont chaque ligne de rang l, avec l entier allant de 1 à p, est constituée par un vecteur comprenant (l-1)*n coefficients nuls suivis de n coefficients unitaires suivis de (p-l)*n nuls, le dispositif électronique de traitement (403) comportant :

   - un premier étage (407) adapté, à chaque fourniture d'un vecteur $L_i$ par le capteur et avant la fourniture du vecteur $L_i$ suivant, à multiplier les k valeurs $L_i(j)$ du vecteur $L_i$ par respectivement k coefficients $b_i(j)$, et à fournir un vecteur $T1_i$ de k valeurs $T1_i(j)$ résultant de cette multiplication ;
   - un deuxième étage (409) adapté, à chaque fourniture d'un vecteur $T1_i$ par le premier étage (407) et avant la fourniture du vecteur $T1_i$ suivant, à multiplier le vecteur $T1_i$ par une matrice $\tilde{A}$ de k*p coefficients, et à fournir un vecteur $T2_i$ de p valeurs $T2_i(l)$ résultant de cette multiplication, où l est un entier allant de 1 à p ; et
   - un troisième étage (411) adapté à intégrer numériquement les n vecteurs $T2_i$ successivement fournis par le deuxième étage (409), et à fournir un vecteur de sortie IT de p valeurs IT(l), correspondant à la projection G(A,B)*I.

2. Système électronique comportant :

   un capteur (201 ; 700 ; 900) adapté à fournir successivement n vecteurs $L_i$ comportant chacun k valeurs mesurées $L_i(j)$, où n et k sont des entiers avec n ≥ 2 et k ≥ 1, i est un entier allant de 1 à n, et j est un entier allant de 1 à k ; et
   un dispositif électronique (603) de traitement à la volée des valeurs mesurées par le capteur adapté à fournir une projection $\check{G}(A,B)*I$, dans un domaine de représentation de dimension p, de l'ensemble des n*k valeurs $L_i(j)$ mesurées par le capteur, p étant un entier avec p ≥ 1, I étant un vecteur colonne de n*k valeurs, constitué par l'ensemble des n*k valeurs $L_i(j)$ mesurées par le capteur, et $\check{G}(A,B)$ étant une matrice de projection de p lignes et n*k colonnes telle que Ĝ(A,B)=S*B*A, où B est une matrice carrée diagonale de p*n colonnes par p*n lignes, où A est une matrice de n*k colonnes par p*n lignes constituée de p*k sous-matrices carrées de dimensions n*n disposées selon p lignes et k colonnes, chaque sous matrice carrée étant une matrice diagonale dont les n valeurs de la diagonale sont identiques, et où S est une matrice de p lignes par p*n colonnes dont chaque ligne de rang l, avec l entier allant de 1 à p, est constituée par un vecteur comprenant (l-1)*n coefficients nuls suivis de n coefficients unitaires suivis de (p-l)*n nuls, le dispositif électronique de traitement (403) comportant :

- un premier étage (607) adapté, à chaque fourniture d'un vecteur $L_i$ par le capteur et avant la fourniture du vecteur $L_i$ suivant, à multiplier le vecteur $L_i$ par une matrice Ã de k*p coefficients, et à fournir un vecteur $T1_i$ de p valeurs $T1_i(l)$ résultant de cette multiplication, où 1 est un entier allant de 1 à p ;
- un deuxième étage (609) adapté, à chaque fourniture d'un vecteur $T1_i$ par le premier étage et avant la fourniture du vecteur $T1_i$ suivant, à multiplier les p valeurs $T1_i(l)$ du vecteur $T1_i$ par respectivement p coefficients $b_i(l)$, et à fournir un vecteur $T2_i$ de p valeurs $T2_i(l)$ résultant de cette multiplication ; et
- un troisième étage (611) adapté à intégrer numériquement les n vecteurs $T2_i$ successivement fournis par le deuxième étage (609), et à fournir un vecteur de sortie IT de p valeurs IT(l), correspondant à la projection G(A,B)*I.

3. Système selon la revendication 1 ou 2, dans lequel les premier (407 ; 607), deuxième (409 ; 609) et troisième (411 ; 611) étages sont cascadés et sont cadencés par un même signal d'horloge, de façon que chaque étage réalise l'opération de calcul qui lui est attribuée entre deux fronts montants ou descendants consécutifs du signal d'horloge.

4. Système selon l'une quelconque des revendications 1 à 3, dans lequel k est un entier supérieur ou égal à 2.

5. Système selon l'une quelconque des revendications 1 à 4, dans lequel le dispositif de traitement comporte en outre un quatrième étage (413 ; 613) adapté à recevoir le vecteur IT de dimension p fourni par le troisième étage (411 ; 611), et à prendre une ou plusieurs décisions en fonction de la valeur du vecteur IT.

6. Système selon la revendication 5, dans lequel le quatrième étage (413 ; 613) est adapté à classer l'ensemble des n*k valeurs mesurées par le capteur dans une catégorie choisie parmi une pluralité de catégories prédéfinies, en fonction de la valeur du vecteur IT.

7. Système selon la revendication 5, dans lequel le quatrième étage (413 ; 613) est adapté à commander un dispositif électronique utilisateur en fonction de la valeur du vecteur IT.

8. Système selon l'une quelconque des revendications 1 à 7, dans lequel le capteur (201) est un capteur d'images comportant une pluralité de pixels disposés selon n lignes et k colonnes, adapté à fournir successivement n vecteurs $L_i$, chaque vecteur $L_i$ correspondant à l'ensemble des valeurs de sortie des pixels d'une même ligne du capteur.

9. Système selon la revendication 8, dans lequel les valeurs de sortie des pixels du capteur (201) sont des valeurs numériques quantifiées sur plusieurs bits.

10. Système selon la revendication 8, dans lequel les valeurs de sortie des pixels du capteur (201) sont des valeurs binaires, et dans lequel le capteur est lu une pluralité de fois, le dispositif de traitement (403 ; 603) fournissant, à chaque lecture, une projection de l'image binaire fournie par le capteur, le système étant adapté à additionner les projections des images binaires successivement fournies par le dispositif de traitement (403 ; 603) pour fournir une image projetée finale.

11. Système selon l'une quelconque des revendications 1 à 7, dans lequel le capteur (700 ; 900) est un capteur d'histogrammes comportant un capteur photosensible multi-spectral asynchrone (701) et un circuit de construction d'histogrammes (703 ; 903) dont une entrée est reliée à une sortie du capteur photosensible (701).

12. Système selon la revendication 11, dans lequel le circuit de construction d'histogrammes (703 ; 903) est adapté à fournir k histogrammes ($h_1$, ..., $h_k$) d'une scène vue par le capteur photosensible (701), correspondant respectivement à k bandes spectrales ($\lambda_1$, ..., $\lambda_k$) différentes de la scène.

13. Système selon la revendication 12, dans lequel le circuit de construction d'histogrammes (903) est adapté à fournir, pour chaque bande spectrale ($\lambda_j$), m histogrammes ($h_{j1}$, ..., $h_{jm}$) de la scène présentant des échelles différentes.

**14.** Système selon l'une quelconque des revendications 1 à 13, comportant une pluralité de capteurs (201 ; 700 ; 900) identiques juxtaposés, et, pour chaque capteur, un dispositif électronique (403 ; 603) de traitement à la volée des valeurs mesurées par le capteur, le système étant adapté à, pour chaque capteur, classer un ensemble de valeurs mesurées par le capteur dans une catégorie choisie parmi une pluralité de catégories prédéfinies, en fonction de la valeur du vecteur IT calculée par le dispositif de traitement associé au capteur.

**15.** Système selon l'une quelconque des revendications 1 à 14, comprenant en outre un dispositif électronique d'apprentissage comprenant :

- une mémoire de référence stockant au moins une valeur de référence correspondant par exemple à des coefficients d'une projection de référence G ou à au moins un couple de valeurs d'entrée/sortie de référence, chaque couple incluant un vecteur de référence I et un vecteur de référence IT associé attendu ;
- un dispositif de calcul d'optimum apte à rechercher des coefficients des matrices A et B permettant de s'approcher au mieux de ladite au moins une valeur de référence ; et
- un dispositif d'écriture des coefficients des matrices A et B dans une mémoire de stockage du dispositif électronique de traitement (403, 603), les valeurs mémorisées pouvant être modifiées pendant un processus d'apprentissage sur requête du dispositif de calcul d'optimum.

**Patentansprüche**

1. Ein elektronisches System, das Folgendes aufweist:

   einen Sensor (201; 700; 900), der in der Lage ist, n Vektoren $L_i$ nacheinander zu liefern, die jeweils k Messwerte Li(j) aufweisen, wobei n und k ganze Zahlen mit $n \geq 2$ und $k \geq 1$ sind, i eine ganze Zahl im Bereich von 1 bis n ist und j eine ganze Zahl im Bereich von 1 bis k ist; und
   eine elektronische Vorrichtung (403) zur sofortigen Verarbeitung der vom Sensor gemessenen Werte, die in der Lage ist, eine Projektion $\hat{G}(A,B)*I$ des vom Sensor gemessenen Satzes von n*k Werten $L_i(j)$ in einem Darstellungsbereich der Dimension p zu liefern, wobei p eine ganze Zahl mit $p \geq 1$ ist, I ein Spaltenvektor von n*k Werten ist, der durch den Satz von n*k Werten $L_i(j)$ gebildet wird, die vom Sensor gemessen werden, und $\hat{G}(A,B)$ eine Projektionsmatrix mit p Zeilen und n*k Spalten ist, sodass $\hat{G}(A,B) = S*A*B$, wobei B eine quadratische Diagonalmatrix mit n*k Zeilen und n*k Spalten ist und A eine Matrix mit n*k Spalten und p*n Zeilen ist, die aus p*k quadratischen Untermatrizen der Dimension n*n gebildet wird, die in p Zeilen und k Spalten angeordnet sind, wobei jede quadratische Untermatrix eine Diagonalmatrix mit n identischen Werten auf ihrer Diagonalen ist, und wobei S eine Matrix mit p Zeilen und p*n Spalten ist, wobei jede Zeile den Rang I hat, wobei I eine ganze Zahl im Bereich von 1 bis p ist, gebildet durch einen Vektor, der (I-1)*n Nullkoeffizienten, gefolgt von n Einheitenkoeffizienten, gefolgt von (p-I)*n Nullkoeffizienten aufweist, wobei die elektronische Verarbeitungsvorrichtung (403) aufweist:

   - eine erste Stufe (407), die jedes Mal, wenn ein Vektor $L_i$ vom Sensor geliefert wurde und bevor der nächste Vektor $L_i$ geliefert wird, in der Lage ist, die k Werte $L_i(j)$ des Vektors Li mit jeweils k Koeffizienten $b_i(j)$ zu multiplizieren und einen Vektor $T1_i$ mit k Werten $T1_i(j)$ zu liefern, die sich aus der Multiplikation ergeben;
   - eine zweite Stufe (409), die jedes Mal, wenn ein Vektor $T1_i$ von der ersten Stufe (407) geliefert wurde und bevor der nächste Vektor $T1_i$ geliefert wird, in der Lage ist, den Vektor $T1_i$ mit einer Matrix Ã aus k*p Koeffizienten zu multiplizieren und einen Vektor $T2_i$ aus p Werten $T2_i(l)$ zu liefern, die sich aus der Multiplikation ergeben, wobei I eine ganze Zahl im Bereich von 1 bis p ist; und
   - eine dritte Stufe (411), die in der Lage ist, die n Vektoren $T2_i$, die nacheinander von der zweiten Stufe (409) geliefert werden, digital zu integrieren und einen Ausgabevektor IT mit p Werten IT(I) zu liefern, der der Projektion $\hat{G}(A,B)*I$ entspricht.

2. Ein elektronisches System, das Folgendes aufweist:

   einen Sensor (201; 700; 900), der in der Lage ist, n Vektoren $L_i$ nacheinander zu liefern, die jeweils k Messwerte $L_i$(j) aufweisen, wobei n und k ganze Zahlen mit $n \geq 2$ und $k \geq 1$ sind, i eine ganze Zahl im Bereich von 1 bis n ist und j eine ganze Zahl im Bereich von 1 bis k ist; und
   eine elektronische Vorrichtung (603) zur sofortigen Verarbeitung der vom Sensor gemessenen Werte, das in der Lage ist, eine Projektion $\hat{G}(A,B)*I$ in einem Darstellungsbereich der Dimension p der Menge von n*k Werten Li(j) zu liefern, die vom Sensor gemessen wurden, wobei p eine ganze Zahl mit $p \geq 1$ ist, I ein Spaltenvektor von $n*k$ Werten ist, der durch die Menge von $n*k$ Werten $Li(j)$ gebildet wird, die vom Sensor gemessen wurden, und $\hat{G}(A,B)$ eine Projektionsmatrix mit p Zeilen und $n*k$ Spalten ist, so dass $\hat{G}(A,B)=S*B*A$, wobei B eine quadratische Diagonalmatrix mit $p*n$ Spalten und $p*n$ Zeilen ist, wobei A eine Matrix mit $n*k$ Spalten und $p*n$ Zeilen ist, die aus $p*k$ quadratischen Untermatrizen der Dimension $n*n$ gebildet wird, die in p Zeilen und k Spalten angeordnet sind, wobei jede quadratische Untermatrix eine Diagonalmatrix mit n identischen Werten auf ihrer Diagonalen ist, und wobei S eine Matrix mit p Zeilen und $p*n$ Spalten ist, wobei jede Zeile den Rang I hat, wobei I eine ganze Zahl im Bereich von 1 bis p ist, gebildet durch einen Vektor, der $(I-1)*n$ Nullkoeffizienten, gefolgt von n Einheitenkoeffizienten, gefolgt von $(p-I)*n$ Nullkoeffizienten aufweist, wobei die elektronische Verarbeitungsvorrichtung (403) aufweist:

- eine erste Stufe (607), die jedes Mal, wenn ein Vektor $L_i$ vom Sensor geliefert wurde und bevor der nächste Vektor $L_i$ geliefert wird, den Vektor $L_i$ mit einer Matrix $\tilde{A}$ aus $k*p$ Koeffizienten multiplizieren und einen Vektor $T1_i$ aus p Werten $T1_i(I)$ liefern kann, die sich aus der Multiplikation ergeben, wobei I eine ganze Zahl im Bereich von 1 bis p ist;
- eine zweite Stufe (609), die jedes Mal, wenn ein Vektor $T1_i$ von der ersten Stufe geliefert wurde und bevor der nächste Vektor T1i geliefert wird, in der Lage ist, die p Werte $T1_i(I)$ des Vektors $T1_i$ mit jeweils p Koeffizienten bi(I) zu multiplizieren und einen Vektor $T2_i$ mit p Werten $T2_i(I)$ zu liefern, die aus der Multiplikation resultieren; und
- eine dritte Stufe (611), die in der Lage ist, die n Vektoren $T2_i$, die nacheinander von der zweiten Stufe (609) geliefert werden, digital zu integrieren und einen Ausgabevektor IT mit p Werten IT(I) zu liefern, der der Projektion $\hat{G}(A,B)*I$ entspricht.

3. Das System nach Anspruch 1 oder 2, wobei die erste (407; 607), zweite (409; 609) und dritte (411; 611) Stufe kaskadiert und durch dasselbe Taktsignal getaktet sind, so dass jede Stufe die ihr zugewiesene Rechenoperation zwischen zwei aufeinanderfolgenden steigenden oder fallenden Flanken des Taktsignals ausführt.

4. Das System nach einem der Ansprüche 1 bis 3, wobei k eine ganze Zahl größer oder gleich 2 ist.

5. Das System nach einem der Ansprüche 1 bis 4, wobei die Verarbeitungsvorrichtung ferner eine vierte Stufe (413; 613) aufweist, die in der Lage ist, den von der dritten Stufe (411; 611) gelieferten Vektor IT der Dimension p zu empfangen und eine oder mehrere Entscheidungen entsprechend dem Wert des Vektors IT zu treffen.

6. Das System nach Anspruch 5, wobei die vierte Stufe (413; 613) in der Lage ist, den Satz von $n*k$ Werten, die vom Sensor gemessen werden, entsprechend dem Wert des Vektors IT in eine ausgewählte Kategorie aus einer Vielzahl von vordefinierten Kategorien einzuteilen.

7. Das System nach Anspruch 5, wobei die vierte Stufe (413; 613) in der Lage ist, eine elektronische Vorrichtung eines Benutzers entsprechend dem Wert des Vektors IT zu steuern.

8. System nach einem der Ansprüche 1 bis 7, wobei der Sensor (201) ein Bildsensor ist, der eine Vielzahl von Pixeln aufweist, die in n Zeilen und k Spalten angeordnet sind, und der in der Lage ist, n Vektoren $L_i$ nacheinander zu liefern, wobei jeder Vektor $L_i$ allen Ausgangswerten der Pixel einer gleichen Zeile des Sensors entspricht.

9. Das System nach Anspruch 8, wobei die Ausgangswerte der Sensor-Pixel (201) digitale Werte sind, die über eine Vielzahl von Bits quantisiert sind.

10. Das System nach Anspruch 8, wobei die Ausgangswerte der Sensor-Pixel (201) binäre Werte sind und wobei der Sensor mehrfach ausgelesen wird, wobei die Verarbeitungsvorrichtung (403; 603) für jeden Lesevorgang eine Projektion des vom Sensor gelieferten Binärbildes liefert, wobei das System in der Lage ist, die von der Verarbeitungsvorrichtung (403; 603) nacheinander gelieferten Projektionen der Binärbilder zu addieren, um ein endgültiges projiziertes Bild zu liefern.

11. System nach einem der Ansprüche 1 bis 7, wobei der Sensor (700; 900) ein Histogrammsensor ist, der einen asynchronen multispektralen lichtempfindlichen Sensor (701) und eine Histogramm-Konstruktionsschaltung (703; 903) aufweist, deren Eingang mit einem Ausgang des lichtempfindlichen Sensors (701) verbunden ist.

12. System nach Anspruch 11, wobei die Histogramm-Konstruktionsschaltung (703; 903) in der Lage ist, k Histogramme

($h_1$, ..., $h_k$) einer vom lichtempfindlichen Sensor (701) gesehenen Szene zu liefern, die jeweils k verschiedenen Spektralbändern ($\lambda_1$, ..., $\lambda_k$) der Szene entsprechen.

13. System nach Anspruch 12, wobei die Histogramm-Konstruktionsschaltung (903) in der Lage ist, für jedes Spektralband ($\lambda_j$) m Histogramme ($h_j 1$, ..., $h_j m$) der Szene mit unterschiedlichen Skalen zu liefern.

14. System nach einem der Ansprüche 1 bis 13, aufweisend eine Vielzahl von nebeneinander angeordneten identischen Sensoren (201; 700; 900) und für jeden Sensor eine elektronische Vorrichtung (403; 603) zur sofortigen Verarbeitung der vom Sensor gemessenen Werte aufweist, wobei das System in der Lage ist, für jeden Sensor einen Satz von Werten, die vom Sensor gemessen wurden, in eine ausgewählte Kategorie aus einer Vielzahl von vordefinierten Kategorien einzuteilen, entsprechend dem Wert des Vektors IT, der von der dem Sensor zugeordneten Verarbeitungsvorrichtung berechnet wurde.

15. Das System nach einem der Ansprüche 1 bis 14, das ferner eine elektronische Trainingsvorrichtung aufweist, die Folgendes aufweist:

- einen Referenzspeicher, der mindestens einen Referenzwert speichert, der beispielsweise den Koeffizienten einer Referenzprojektion G oder mindestens einem Paar von Referenzeingangs-/Ausgangswerten entspricht, wobei jedes Paar einen Referenzvektor I und einen erwarteten zugehörigen Referenzvektor IT aufweist;
- eine Vorrichtung zur Berechnung von Optimalwerten, die in der Lage ist, nach Koeffizienten der Matrizen A und B zu suchen, die es ermöglichen, sich dem mindestens einen Referenzwert bestmöglich anzunähern; und
- eine Vorrichtung zum Schreiben der Koeffizienten der Matrizen A und B in einen Speicher der elektronischen Verarbeitungsvorrichtung (403, 603), wobei die gespeicherten Werte während eines Trainingsprozesses auf Anforderung der Vorrichtung zur Berechnung von Optimalwerten geändert werden können.

**Claims**

1. An electronic system comprisig:

a sensor (201; 700; 900) capable of successively supplying n vectors $L_i$ each comprising k measured values $L_i(j)$, where n and k are integers with $n \geq 2$ and $k \geq 1$, i is an integer in the range from 1 to n, and j is an integer in the range from 1 to k; and
an electronic device (403) for processing on the fly the values measured by the sensor, capable of providing a projection , in a representation domain of dimension p, of the set of n*k values $L_i(j)$ measured by the sensor, p being an integer with $p \geq 1$, I being a column vector of n*k values, formed by the set of n*k values $L_i(j)$ measured by the sensor, and **Ĝ(A,B)** being a projection matrix of p rows and n*k columns such that **Ĝ(A,B)=S\*A\*B,** where B is a square diagonal matrix with n*k rows and n*k columns, and A is a matrix of n*k columns and p*n rows formed of p*k square sub-matrices of dimensions n*n arranged in p rows and k columns, each square sub-matrix being a diagonal matrix having n identical values on its diagonal, and where S is a matrix of p rows and p*n columns, having each row of rank 1, I being an integer in the range from 1 to p, formed by a vector comprising (I-1)*n zero coefficients followed by n unit coefficients followed by (p-I)*n zero coefficients, the electronic processing device (403) comprising:

- a first stage (407) capable, each time a vector $L_i$ has been supplied by the sensor and before the next vector $L_i$ is supplied, of multiplying the k values $L_i(j)$ of vector $L_i$ by respectively k coefficients $b_i(j)$, and of supplying a vector $T1_i$ of k values $T1_i(j)$ resulting from the multiplication;
- a second stage (409) capable, each time a vector $T1_i$ has been supplied by the first stage (407) and before the next vector $T1_i$ is supplied, of multiplying vector $T1_i$ by a matrix **Ã** of k*p coefficients, and of supplying a vector $T2_i$ of p values $T2_i(I)$ resulting from the multiplication, where I is an integer in the range from 1 to p; and
- a third stage (411) capable of digitally integrating the n vectors $T2_i$ successively supplied by the second stage (409) and of supplying an output vector IT of p values IT(I), corresponding to projection **Ǧ(A,B)\*I,**

2. An electronic system comprising:

a sensor (201; 700; 900) capable of successively supplying n vectors $L_i$ each comprising k measured values $L_i(j)$, where n and k are integers with $n \geq 2$ and $k \geq 1$, i is an integer in the range from 1 to n, and j is an integer in the range from 1 to k; and

an electronic device (603) for processing on the fly the values measured by the sensor, capable of providing a projection **Ĝ(A,B)\*l** , in a representation domain of dimension p, of the set of n\*k values $L_i(j)$ measured by the sensor, p being an integer with p ≥ 1, l being a column vector of n\*k values, formed by the set of n\*k values $L_i(j)$ measured by the sensor, and **Ĝ(A,B)** being a projection matrix of p rows and n\*k columns such that **Ĝ(A,B) =S\*B\*A,** where B is a square diagonal matrix with p\*n columns and p\*n rows, where A is a matrix of n\*k columns and p\*n rows formed of p\*k square sub-matrices of dimensions n\*n arranged in p rows and k columns, each square sub-matrix being a diagonal matrix having n identical values on its diagonal, and where S is a matrix of p rows and p\*n columns, having each row of rank 1, l being an integer in the range from 1 to p, formed by a vector comprising (l-1)\*n zero coefficients followed by n unit coefficients followed by (p-l)\*n zero coefficients, the electronic processing device (403) comprising:

- a first stage (607) capable, each time a vector $L_i$ has been supplied by the sensor and before the next vector $L_i$ is supplied, of multiplying vector $L_i$ by a matrix **Ã** of k\*p coefficients, and of supplying a vector $T1_i$ of p values $T1_i(l)$ resulting from the multiplication, where 1 is an integer in the range from 1 to p;
- a second stage (609) capable, each time a vector $T1_i$ has been supplied by the first stage and before the next vector $T1_i$ is supplied, of multiplying the p values $T1_i(l)$ of vector $T1_i$ by respectively p coefficients $b_i(l)$, and of supplying a vector $T2_i$ of p values $T2_i(l)$ resulting from the multiplication; and
- a third stage (611) capable of digitally integrating the n vectors $T2_i$ successively supplied by the second stage (609) and of supplying an output vector IT of p values IT(l), corresponding to projection **Ĝ(A,B)\*l.**

3. The system of claim 1 or 2, wherein the first (407; 607), second (409; 609), and third (411; 611) stages are cascaded and rated by a same clock signal, so that each stage executes the calculation operation which is assigned thereto between two consecutive rising or falling edges of the clock signal.

4. The system of any of claims 1 to 3, wherein k is an integer greater than or equal to 2.

5. The system of any of claims 1 to 4, wherein the processing device further comprises a fourth stage (413; 613) capable of receiving vector IT of dimension p supplied by the third stage (411; 611) and of making one or a plurality of decisions according to the value of vector IT.

6. The system of claim 5, wherein the fourth stage (413; 613) is capable of classifying the set of n\*k values measured by the sensor in a selected category from a plurality of predefined categories, according to the value of vector IT.

7. The system of claim 5, wherein the fourth stage (413; 613) is capable of controlling a user electronic device according to the value of vector IT.

8. The system of any of claims 1 to 7, wherein the sensor (201) is an image sensor comprising a plurality of pixels arranged in n rows and k columns, capable of successively supplying n vectors $L_i$, each vector $L_i$ corresponding to all the output values of the pixels of a same row of the sensor.

9. The system of claim 8, wherein the output values of the sensor pixels (201) are digital values quantized over a plurality of bits.

10. The system of claim 8, wherein the output values of the sensor pixels (201) are binary values, and wherein the sensor is read from a plurality of times, the processing device (403; 603) supplying, for each read operation, a projection of the binary image supplied by the sensor, the system being capable of adding the projections of the binary images successively supplied by the processing device (403; 603) to supply a final projected image.

11. The system of any of claims 1 to 7, wherein the sensor (700; 900) is a histogram sensor comprising an asynchronous multispectral photosensitive sensor (701) and a histogram construction circuit (703; 903) having an input connected to an output of the photosensitive sensor (701).

12. The system of claim 11, wherein the histogram construction circuit (703; 903) is capable of supplying k histograms $(h_1, ..., h_k)$ of a scene seen by the photosensitive sensor (701), respectively corresponding to k different spectral bands $(\lambda_1, ..., \lambda_k)$ of the scene.

13. The system of claim 12, wherein the histogram construction circuit (903) is capable of supplying, for each spectral band $(\lambda_j)$, m histograms $(h_{j1}, ..., h_{jm})$ of the scene having different scales.

14. The system of any of claims 1 to 13, comprising a plurality of juxtaposed identical sensors (201; 700; 900) and, for each sensor, an electronic device (403; 603) for processing on the fly the values measured by the sensor, the system being capable of, for each sensor, classifying a set of values measured by the sensor in a selected category from a plurality of predefined categories, according to the value of the vector IT calculated by the processing device associated with the sensor.

15. The system of any of claims 1 to 14, further comprising an electronic training device comprising:

- a reference memory storing at least one reference value for example corresponding to coefficients of a reference projection G or to at least a pair of reference input/output values, each pair including a reference vector I and an expected associated reference vector IT;
- an optimum value calculation device capable of searching for coefficients of matrices A and B enabling to approach at best said at least one reference value; and
- a device for writing the coefficients of matrices A and B into a storage memory of the electronic processing device (403, 603), where the stored values may be modified during a training process on request of the optimum value calculation device.

Fig 1

Fig 2

Fig 3

Fig 4

Fig 5

Fig 6

Fig 7

Fig 8

900

$P_1(\lambda_1)$    701    $P_1(\lambda_1)$    903

$P_k(\lambda_k)$

705

$P_1(\lambda_1)$   705

$P_k(\lambda_k)$

$P_1(\lambda_1)$   705

$P_k(\lambda_k)$

$h_{11}$
$h_{1m}$   $(\lambda_1)$

$h_{k1}$
$h_{km}$   $(\lambda_k)$

**Fig 9**

$\lambda_1$

$h_{11}$

$h_{12}$

t1
t2

t

$\lambda_k$

$h_{k1}$

$h_{k2}$

t1
t2

t

**Fig 10**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 1660627

**Littérature non-brevet citée dans la description**

- **M. F. DUARTE** ; **Y. C. ELDAR**. Structured Compressed Sensing: From Theory to Applications. *IEEE Transactions on Signal Processing*, September 2011, vol. 59 (9), 4053-4085

- **JOHNSON, JUAN EMMANUEL**. Schroedinger Eigenmaps for Manifold Alignment of Multimodal Hyperspectral Images. Thesis. Rochester Institute of Technology, 2016